(19) Europäisches Patentamt
European Patent Office
Office européen des brevets

(11) **EP 4 786 792 A1**

(12) **EUROPEAN PATENT APPLICATION**

(43) Date of publication:
**05.08.2026 Bulletin 2026/32**

(21) Application number: **26154320.1**

(22) Date of filing: **27.01.2026**

(51) International Patent Classification (IPC):
**F04D 17/16** (2006.01)     **F04D 19/00** (2006.01)
**F04D 27/00** (2006.01)     **G05B 23/02** (2006.01)
**H05K 7/20** (2006.01)

(52) Cooperative Patent Classification (CPC):
**F04D 27/001; F04D 17/16; F04D 19/002;
G05B 23/0283; H05K 7/20209; H05K 7/20727**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.01.2025 US 202563751040 P
20.01.2026 US 202619453044**

(71) Applicant: **Vertiv International GmbH
8212 Neuhausen am Rheinfall (CH)**

(72) Inventor: **BERNINI, Fabrizio
Westerville, 43082 (US)**

(74) Representative: **Bryn-Jacobsen, Caelia et al
Kilburn & Strode LLP
Lacon London
84 Theobalds Road
London WC1X 8NL (GB)**

(54) **CONDITION-BASED HEALTH METER**

(57)     A controller for controlling at least one cooling fan associated with a component of a system includes memory storing instructions and one or more processors configured to execute the instructions. Executing the instructions causes controller to obtain operating characteristic values corresponding to at least a running time of the at least one cooling fan, a temperature associated with the at least one cooling fan, and a rotation speed of the at least one cooling fan, calculate a value indicative of a remaining life of the at least one cooling fan based on the operating characteristic values, and perform at least one function associated with the operation of the system based on the value indicative of the remaining life.

EP 4 786 792 A1

**Description**

CROSS-REFERENCE TO RELATED APPLICATIONS

This application claims the benefit of U.S. Provisional Application No. 63/751,040, filed on January 29, 2025, and U.S. Non-Provisional Application No. 19/453,044, filed on January 20, 2026.

FIELD

The present disclosure relates to systems and methods for monitoring remaining life of cooling fans for various systems.

BACKGROUND

The background description provided here is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

Various electrical, mechanical, and electromechanical systems include one or more components that require cooling to facilitate operation, prevent mechanical failures, and extend operating life. For example, information technology environments (e.g., data centers, cloud computing systems, etc.) typically include cooling infrastructure to provide cooling to servers, server racks, power distribution units (PDUs), and/or other components.

SUMMARY

A controller for controlling at least one cooling fan associated with a component of a system includes memory storing instructions and one or more processors configured to execute the instructions. Executing the instructions causes controller to obtain operating characteristic values corresponding to at least a running time of the at least one cooling fan, a temperature associated with the at least one cooling fan, and a rotation speed of the at least one cooling fan, calculate a value indicative of a remaining life of the at least one cooling fan based on the operating characteristic values, and perform at least one function associated with the operation of the system based on the value indicative of the remaining life.

Further areas of applicability of the present disclosure will become apparent from the detailed description, the claims and the drawings. The detailed description and specific examples are intended for purposes of illustration only and are not intended to limit the scope of the disclosure.

BRIEF DESCRIPTION OF THE DRAWINGS

The present disclosure will become more fully understood from the detailed description and the accompanying drawings, wherein:

FIG. 1 shows an example system including a controller according to the present disclosure;

FIG. 2 shows an example model or algorithm for calculating a health score according to the principles of the present disclosure;

FIG. 3A illustrates example fan-specific information in the form of a lifetime or end of life curve showing the relationship between equipment estimated life and the average temperature the item is exposed to during its full lifetime according to the principles of the present disclosure;

FIG. 3B illustrates example temperature dependencies and their inverses according to the principles of the present disclosure;

FIG. 3C illustrates a ratio r as a function of elapsed time at different temperatures according to the principles of the present disclosure;

FIGS. 3D, 3E, and 3F illustrate various examples of health scores calculated according to the principles of the present disclosure;

FIG. 4 shows a block diagram of an example computing device configured to implement functions of the systems and methods of the present disclosure;

FIG. 5 shows an example method for calculating a remaining life of a cooling fan in accordance with the principles of the present disclosure.

In the drawings, reference numbers may be reused to identify similar and/or identical elements.

DETAILED DESCRIPTION

Reference will now be made in detail to examples which are illustrated in the accompanying drawings, wherein like reference numerals refer to like elements throughout. In this regard, the examples s may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "approximately" may correspond to "within +/- 5% of."

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names. As such, this document does not intend to distinguish between components that differ in name but not function.

Matters of these examples that are obvious to those of ordinary skill in the technical field to which these examples pertain may not be described herein in detail.

Various electrical, mechanical, and electromechanical systems include one or more components that require cooling to facilitate operation, prevent mechanical failures, and extend operating life. For example, information technology environments (e.g., data centers, cloud computing systems, etc.) typically include cooling infrastructure to provide cooling to servers, server racks, power distribution units (PDUs), and/or other components.

As one example, servers (e.g., server computing systems, such as rack servers) typically include one or more types of cooling systems, including, but not limited to, air cooling systems, direct-to-chip (e.g., liquid-based) cooling systems, and combinations thereof. Various cooling systems may further include components such as cooling fans.

Systems and methods according to the present disclosure are configured to monitor/determine a remaining life of one or more cooling fans in a cooling system, such as a cooling system configured to provide cooling to components of a data center or other IT infrastructure. Typically, cooling fans undergo regular maintenance, servicing, replacement, etc. to ensure that sufficient cooling is provided to critical components. In some examples, maintenance is performed periodically (e.g., at fixed, scheduled intervals) to avoid failure of cooling fans during operation. Accordingly, maintenance may be performed unnecessarily. Systems and methods of the present disclosure calculate/predict a remaining life of one or more cooling fans to minimize unnecessary maintenance/replacement.

The systems and methods of the present disclosure minimize the need for human intervention in various environments and, correspondingly, reduce human error associated with maintenance of cooling system components such as cooling fans. Costs and disruption of operation associated with scheduled maintenance are also reduced.

In various examples described below in more detail, systems and methods of the present disclosure are configured to calculate the remaining life (e.g., a remaining operational period prior to failure and/or effectiveness being reduced below a threshold) of cooling fans based on operating characteristics including, but not limited to, time (e.g., a total running time/runtime), temperature (e.g., a temperature that the cooling fan is exposed to), and rotation/rotating speed. For example, the operating characteristics are monitored over an entire operating history of a cooling fan and calculations may be performed continuously in real-time or periodically (e.g., hourly, daily, etc.).

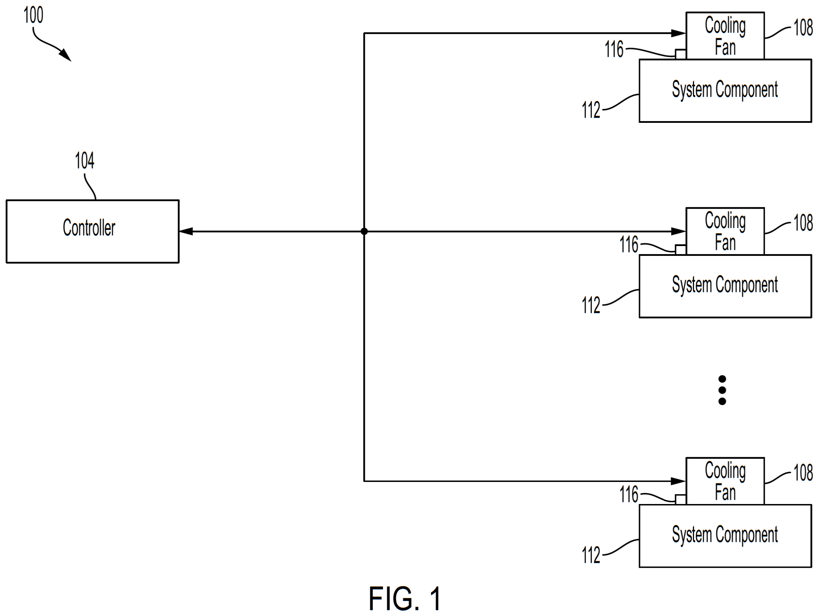

FIG. 1 shows an example system 100 including a controller 104 configured to implement a condition-based calculation or monitoring ("CBM") of remaining life of one or more cooling fans 108 according to the principles of the present disclosure. For example only, the system 100 may correspond to an IT infrastructure, such as a data center, cloud or other distributed computing system, etc. The cooling fans 108 are arranged to provide cooling for respective system components 112 (e.g., electronic, mechanical, and/or electromechanical components, such as servers, server racks, power supplies, etc.) of the system 100. Although shown with one of the cooling fans 108 for each of the system components 112, in some examples two or more of the cooling fans 108 may be arranged to provide cooling to one of the system components 112, one of the cooling fans 108 may be arranged to provide cooling to two or more of the system components 112, etc.

The controller 104 is configured to calculate a respective remaining life of each of the cooling fans 108 as described below in more detail. For example, one or more sensors 116 may be arranged within, on, adjacent to, etc. the cooling fans 108 and/or the system components 112. The controller 104 may be configured to communicate with the sensors 116 (e.g., via wired and/or wireless connections) to receive data indicating various operating characteristics of the cooling fans 108, including, but not limited to, operating characteristics associated with running time, temperature, and rotation speed. In some examples, the sensors 116 are configured to directly sense/measure the operating characteristics (e.g., temperature sensors configured to sense temperature and provide temperature measurements to the controller 104). In other examples, the sensors 116 may be configured to sense/measure variables that are indicative of (and can be used to obtain) values relevant to the operating characteristics (e.g., fan motor voltage or current measurements indicative of runtime, rotation speed, etc.). In other examples, one or more operating characteristics of the cooling fans 108 can be obtained by the controller 104 without sensor measurements (e.g., via modeling or other calculations). For example, the controller 104 may be configured to selectively control operation of the cooling fans 108 (e.g., turn the cooling fans 108 off or on, adjust rotation speeds of the cooling fans 108, etc.). Accordingly, in these examples, the controller 104 may be configured to obtain various operating characteristics in accordance with operation of the controller 104 itself (e.g., based on commands/control signals generated and provide by the controller 104 to the cooling fans 108).

In an example, the controller 104 is configured to implement/execute an algorithm, model, calculation, etc. to monitor trends in operating characteristics of the cooling fans 108 to obtain a value or measurement of "health" or remaining life of the cooling fans 108 and to predict a time to replace and/or perform maintenance on the cooling fans. As used herein, "health" or remaining life can be measured/defined as an integer (e.g., an integer from 0 to 100), a percentage, a value from 0 to 1 (or 1 to 0), etc. For example purposes as discussed herein, health (e.g., a health score, or HS) corresponds to a value between 0 and 1, where 1 indicates a new, fully healthy item/component and 0 indicates an item that is no longer functioning or expected to imminently fail.

For cooling fans, when HS = 0, the fan can simply stop rotating, or lose some parts like a blade, or just run at only a percentage of the speed it is supposed to rotate at (ex.: 85%), resulting in an unacceptable reduction of the amount of heat the fan is supposed to dissipate. Condition-based monitoring techniques according to the present disclosure are configured to provide an opportunity to intervene before the item breaks or fails (e.g., safely enough before HS = 0).

Measuring the health of the fan means necessarily having an idea of how the state of the fan is. This shifts the problem to a slightly different one: finding the state of the fan every day, and also defining the significance of the state. For example, if the noise and vibration produced by the fan can be measured daily, the HS can be calculated as being inversely proportional to the amount of noise produced. Analogously, if the amount of dust on blades of the fan can be measured daily, the HS can be calculated as a function of the amount of dust.

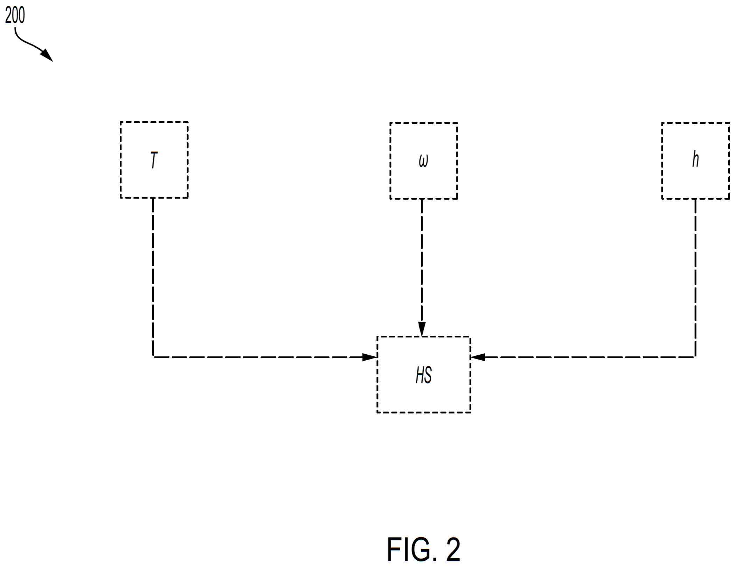

The CBM techniques according to the present disclosure are configured to calculate the HS based on air temperature near the fan (T), fan rotational speed ($\omega$), and number of hours the fan has been "on" (rotating) (h). FIG. 2 shows an example implementation of a model or algorithm configured to calculate the HS for a fan based on the temperature T, fan rotational speed $\omega$, and number of hours h. These variables/characteristics are physically related to the health/deterioration of the fan. For example, temperature and speed affect the lubrication efficiency of the revolving parts, and that this effect accrues/accumulates over time.

In an example with a single fan on a single component/machine, with data for temperature and speed with uninterrupted operation over a known period (e.g., 3 years) and a known day/time of failure, a corresponding dataset can be provided to an algorithm or model (e.g., a machine learning (ML) or other AI model, such as a neural network decision tree, etc.) to predict a remaining life (or HS). However, the accuracy of predictions of an ML or other model increase significantly when the dataset includes data for large numbers (e.g., hundreds or thousands of fans). Conversely, CBM techniques according to the present disclosure are configured to define the state of the fan using a formula or algorithm (e.g., an "estimator") as described below in more detail.

As shown in FIG. 2, the HS according to the present disclosure is a function of temperature, rotation speed, and operating/runtime h. As an example, for this calculation, it assumed that each fan is subject to irreversible deterioration over time (i.e., if no maintenance is performed). Accordingly, the state of the fan depends on the irreversible deterioration or consumption of one or more components of the fan. In the example of the present disclosure, HS can only decrease (e.g., unless maintenance is performed). For example, the condition of the grease or another lubricant that lubricates the fan ball bearings is one example component directly related to the health/remaining life of the fan. As such, grease is consumed by the effect of temperature and speed and is not regenerated. Therefore, the condition of the grease can be used as an indicator of fan health. Less (or less effective grease) corresponds to lower health (and vice versa). In other examples, other components/factors (e.g., amount of dirt on the blades of the fan) can be used.

In other examples, the health score can be set proportional to the estimated remaining life of the item. However, in these examples, the health score may oscillate (i.e., both increase and decrease).

In an example, fan-specific information (e.g., information specific to a particular manufacturer, model, type, etc. of the fan, such as an expected life/lifetime/end of life) can be used to determine a relationship/dependency between the health score and variables such as the temperature, rotational speed, and runtime as described herein. For example, a given fan may have an associated expected lifetime for a specific speed (e.g., a rated speed) and/or temperature (e.g. a temperature range).

Separate/respective contributions of temperature and time during the lifetime of the fan may be determined. For example, a fan may have an optimal working temperature/range (e.g., a temperature range associated with an optimal point of fluidity for the grease/lubricant). Operation below and/or above the temperature/range may accelerate wear/deterioration. Conversely, manufacturer information may indicate that operating at lower temperatures is always preferable. Accordingly, fan-specific information may still be used to determine upper limit temperature constraints while CBM techniques of the present disclosure also consider lower limit temperature constraints. Further, deterioration is not assumed to be constant over time. Rather, as time increases, a rate of wear/deterioration also increases.

Conversely, while rotation speed can contribute to deterioration with some dependency on temperature, rotation speed also contributes to deterioration independently of temperature and time. For example, as rotation speed increases, the rate of wear/deterioration also increases.

Accordingly, CBM techniques according to the present disclosure are configured to calculate the health score using an algorithm/formula based on each of temperature, time and rotational speed. The algorithm may further include a correction factor to align with fan-specific/manufacturer information. For example, the correction factor can be determined in accordance with an assumption that, at an optimal temperature and at a rated speed, the fan should last exactly the number of days the manufacturer indicates for at that temperature. In other words, the correction factor corresponds to a normalization of expected lifetime for a given temperature. Accordingly, incorporating lower temperature constraints according to the principles of the present disclosure causes lower temperatures to further affect the HS calculation.

An example calculation of HS is now described below.

Let *H(t)* be the Health Score time evolution. For the sake of simplicity and standardization, we allow it to span from 0 to 1 only, 1 meaning full health (item new), and 0 meaning need for replacement. Let (t) be the wear of the key element mentioned above. This can be expressed through a number from 0 to 1 as well, where 0 indicates the element new, and 1 indicates all the element has been consumed.

We can define:

$$HS(t) = 1 - W(t) \qquad\qquad\qquad [1\text{-}1],$$

Where *(t)* is positive monotonic and *HS(t)* is negative monotonic.

Regarding fans, we can identify our key element with the grease in the fan motor ball bearings (BB). When there is no more grease around the BB, we assume the health score to be 0. In general, it is not possible to directly monitor the amount of grease in the BB, so an estimator for the health score is used.

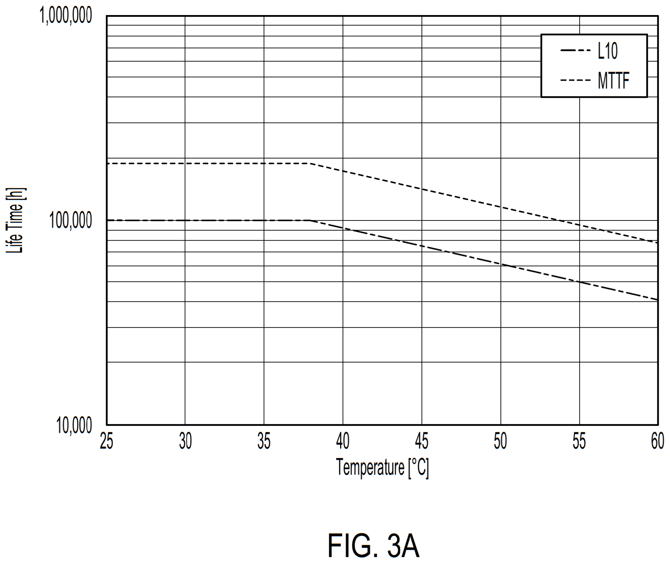

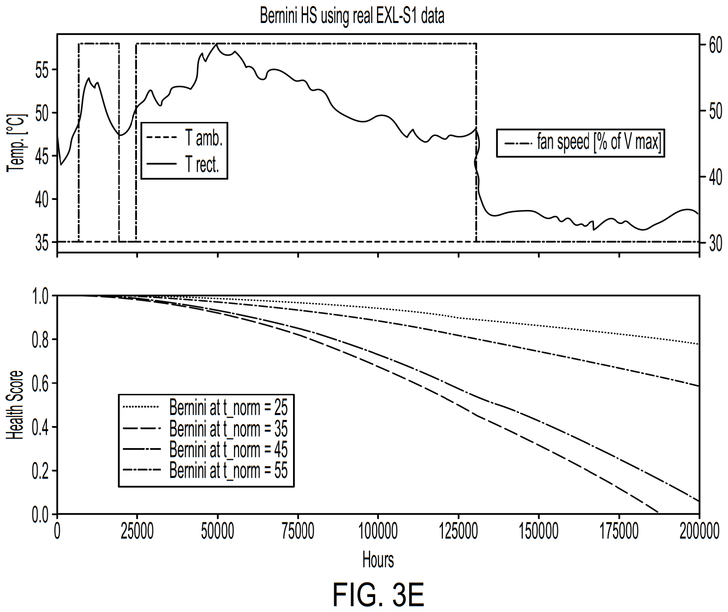

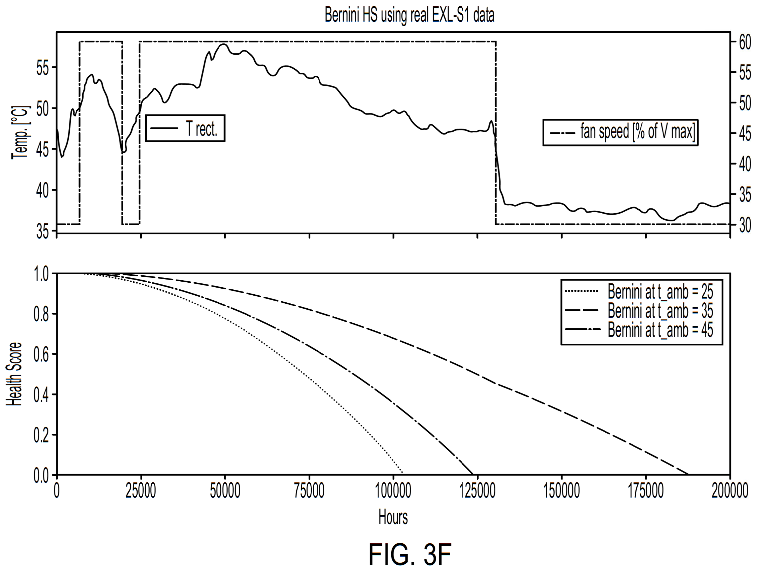

FIG. 3A shows example fan-specific (e.g., manufacturer provided) information in the form of a lifetime or end of life curve showing the relationship between the equipment estimated life (in terms of maximum hours: *hmax*), and the average temperature the item is exposed to during its full lifetime. We identify the average temperature the fan is exposed at during its whole lifetime with the symbol $\overline{T}^*$.

Accordingly, FIG. 3A conveys to us the following physical meaning: up to a temperature $\overline{T}^*$, the expected life is temperature independent. At higher temperatures it experiences a logarithmic decay.

Let g($\overline{T}^*$) be the equation of the considered logarithm, representing the manufacturer curve, specified through the constants A and B. Making use of the Heaviside step function (θ), the maximum fan expected hours ($h_{max}$) can be written as follows:

$$h_{max}(\overline{T}) = [1 - \theta(\overline{T} - \overline{T}^*)] \cdot h_1 + \theta(\overline{T} - \overline{T}^*) \cdot g(\overline{T})$$

$$g(\overline{T}) = 10^{A - B \cdot \overline{T}}$$

$$A = \log_{10} h_2 + B \cdot \overline{T}_2$$

$$B = \frac{\log_{10} \dfrac{h_2}{h_1}}{\overline{T}_2 = \overline{T}_1}$$

The lifetime estimation of rotating devices and motors can be expressed in accordance with:

$$\lambda_p = \beta^3_T \cdot h_2 + \beta_W,$$

where $\lambda_p$ represents the probability of failure after $h$ hours functioning. $\beta_W$ accounts for the windings wear, and $\beta_T$ for the ball bearings wear. The quantities $\beta_T$ and $\beta_W$ depend on the average historical ambient temperature the device has been exposed to.

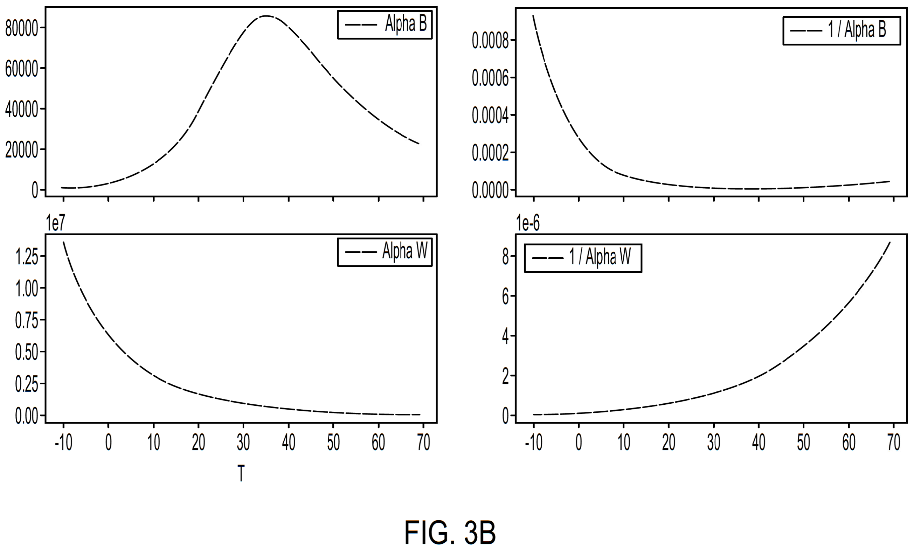

When temperature varies over time we need to consider its rolling mean at each calculation step. FIG. 3B illustrates temperature dependencies and their inverses. The parameters $\alpha$ and $\beta$ are based on Weibull distributions. The Weibull distribution is a model used in reliability and failure examination. The formulas for $\alpha$ and $\beta$ can be expressed as:

$$\beta_T = 10^{(A - \frac{B}{T})} + [10^{(C - \frac{D}{T})} + E]^{-1} \qquad [3\text{-}2]$$

$$\alpha_W = (\beta_W)^{-1} = 10^{(-F - \frac{B}{T})}$$

where A, B, C, D, E and F are suitable constants, and T is temperature expressed in Kelvin.

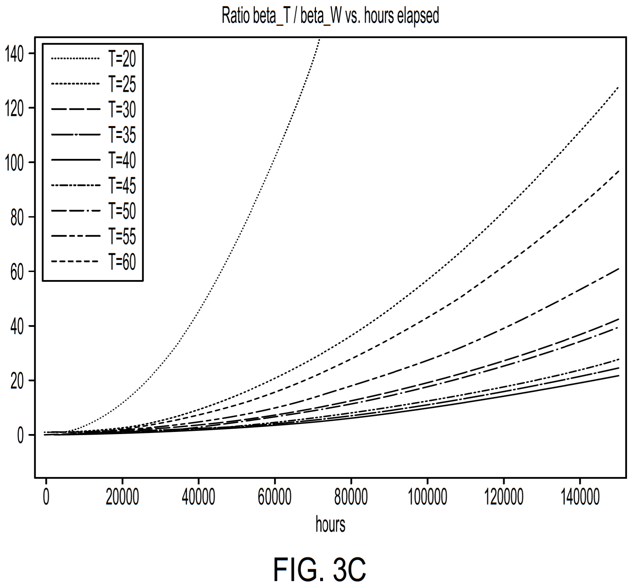

FIG. 3C illustrates a ratio r ($r = \beta_T^3 \cdot h^2/\beta_W$) as a function of elapsed time, computed at different temperatures.

It can be observed that the contribution of $\beta_W$ is stronger at the beginning, but then disappears in time, because only $\beta_T$ is multiplied by time. The highest contribution to the degradation comes from the ball bearings, while the windings wear plays a less important role. For this reason, we choose to neglect $\beta_W$.

Further, it can be observed that it is not clear why the winding term does not depend on time. It would seem logical that the probability of failure related to the windings wear should increase in time, and not stay constant: more time passes, more electric insulation stress should be accumulated on the windings. This suggests that this term may need to be revised. The ratio r needs to be considered at the end of life, once again because the winding term is constant. If we look, for example, at a reasonable value of 100.000 hours, the ratio r spans from a minimum of approx. 10 to near 60, suggesting $\beta_W$ to be neglected in a first approximation. The worst case in this approximation is in the neighborhood of the knee temperature for $\beta_T$ ($T \approx 35°C$).

Various constraints may be considered. For example, maximum motor power can be limited to 1 HP. This is fulfilled if we consider machines like certain power supplies, but it is not fulfilled for fan mounted on cooling systems, for example, where the rated power of the motor can be about 3 kW. However, we can in a first instance try to extend the algorithm to bigger fans. As another example, for DC motors, brushes must be regularly inspected and replaced. This is a constraint to bear in mind, although it would need a separate check using the data coming from field engineers. It is applicable mainly to certain power supplies that mount DC fans. As another example, bearing load may be limited to less than 10% of rated load. As an example,

$$M = 1 - \left(\frac{\omega}{933}\right)^{0.69} \cdot \frac{W}{C_r} \qquad [3\text{-}3]$$

Where:

M is a bearing life reduction coefficient;
$\omega$ is the speed;
W is the applied load [lbs]; and
Cr is the Specific Dynamic Capacity computed at 1/3 of the rated speed.

Our interpretation of the statement "Bearing load to be less than 10% of rated load" is the following: [3-3] can be neglected if $W < 0.1 Cr$. Otherwise, we need to apply a correction factor kL($\omega$) = 1/M to $\lambda_p$, depending on the bearing speed.

As another constraint, motor speed can be limited to less than 24.000 rpm. This condition is normally fulfilled with the kind of motors we are considering, where typical speeds do not exceed 10000 rpm. However, this constraint needs to be checked every time we introduce a new machine.

As still another example constraint, speed slip (s) <= 25%.

In one example study, the lifetime of the fan was found to depend on speed (with a minor secondary dependency on temperature) according to the following relationship:

$$\log L_{50} = 6.54 - 2.6\frac{\omega}{\omega_{lim}} - \left(0.0025 - 0.012\frac{\omega}{\omega_{lim}}\right)T_B \quad \text{("Oh-Azarian formula")},$$

where:

$T_B$ is the ball bearings' temperature;
$\omega_{lim}$ is the limiting speed of the bearings; and
$L_{50}$ is represents the time where half of the items from a big ensemble will fail at.

As in normal cases we do not generally have a direct measure of the ball bearing temperature, we can estimate it using:

$$T_B \approx T_A + 17.5$$

where $TA$ is ambient temperature.

The limiting speed is an empirical value to be provided from the manufacturer, or to be computed with the aid of a table, formula, etc. if the bearing dimensions are known.

Although various formulas herein are provided for a standard or known type of grease, variations with different values, coefficients, etc. can be used for different types of grease.

From the below formula:

$$\lambda_p = \beta_T{}^3 \cdot h^2$$

We isolate the contribution of temperature and time, separately:

$$k_T \triangleq \beta^3(T_A) \qquad \textit{(for temperature)}$$

$$k_h \triangleq h^2 \qquad \textit{(for time)}$$

From the Oh-Azarian formula, we extract a factor to attempt isolating the speed dependency:

$$k'_\omega(\omega, T_B) \triangleq \frac{L_{50}(\omega, T_B)}{L_{50}(\omega_n, T_B)} = 10^{-(2.6+0.012\,T_B)\frac{(\omega-\omega_n)}{\omega_{lim}}}$$

And accordingly:

$$k'_\omega(\omega, T_A) \triangleq 10^{-(2.81+0.012\,T_A)\frac{(\omega-\omega_n)}{\omega_{lim}}}$$

$k'\omega$ represents here the ratio between the fan estimated lifetime at its real speed, and the same lifetime but computed at the rated speed. It is a correction coefficient. The fact we deal with L50 rather than $L$10 or MTTF does not affect our line of reasoning, because we are working with ratios only. However, as the contribution of temperature and time to the MTTF has been set inversely proportional to $\lambda_p$:

$$\text{MTTF} \propto \frac{1}{\lambda_p}$$

we will need the inverse of k'$_\omega$ as the correction factor to be multiplied to $\lambda_p$.

The residual grease in the ball bearing can be defined as g:

$$g = G - \Delta g$$

Where $\Delta g$ is the grease consumed, and $\Delta g/G$ is the fraction of grease consumed, that we can consider proportional to the wear, such that:

$$\mathrm{HS} \triangleq 1 - W = \frac{g}{G} = 1 - \frac{\triangle g}{G}$$

Where W indicates the wear.

It is reasonable to assume the wear and the probability of failure to be proportional, so we can impose:

$$\mathrm{W} = \Delta g/\mathrm{G} \propto \lambda_p$$

We move now from an integral formula to a differential one.

It is important to note how we do not need to consider the rolling averages of temperatures, because we are going to calculate differential intervals. $k_T$ can be interpreted as the rate of grease consumption due to temperature effects, and $k_\omega$ as the rate of grease consumption due to velocity effects.

If we imagine the fan is working at constant temperature and velocity, then $k_T$ and $k_\omega$ will be also constant over time. In this scenario, we can evaluate the amount of wear during the $h^{th}$ hour as:

$$\mathrm{W} \propto \lambda_p = K \cdot k_\omega k_\beta \cdot h^2$$

Where K is a proportionality constant. To simplify the following formulas, we can also define a "reduced" wear:

$$\widetilde{W} = {W}/{K}$$

We consider the version of $k_\omega$ operating on $T_A$ that we will simply call $T$. During the $h^{th}$ hour, the fan will work at the average temperature and velocity (T, $\omega$), being subject to the following (reduced by factor K) wear:

$$\Delta \widetilde{W}_h = k_\omega k_T \cdot h^2 - k_\omega k_\beta \cdot (h-1)^2 = k_\omega k_T \cdot (2h-1)$$

After some simple substitutions:

$$\Delta \widetilde{W}_h = \beta^3(T) \cdot k_\omega(T, \omega) \cdot (2h-1),$$

where we want to stress here again as T and $\omega$ depend on time:

$$T = (h) \text{ and } \omega = \omega(h).$$

To evaluate the cumulative wear in a situation of variable temperature and speed, we simply sum up all the contributes:

$$\widetilde{W}(h) = \sum_{j=1}^{h} \triangle \widetilde{W}_j$$

Finally, combining everything:

$$HS(h) = 1 - K \cdot \widetilde{W}(h) = 1 - K \sum_{j=1}^{h} \beta^3(T) \cdot k_\omega(T, \omega) \cdot (2j - 1)$$

$$|T = T(h), \omega = \omega(h)$$

The above formula can be referred to as the CBM health score.

K represents an unknown proportionality constant. To compute it, we need to impose some constraints and carry out what we will call a "normalization procedure." From the manufacturer information, we extract a constraint on the total lifetime, as a function of temperature, and that is assumed to be valid at the rated speed:

$$H = H(T)$$

where H represents the total amount of hours the machine is expected to last.

Due to the tradeoff mentioned above, we are forced to carry out the normalization only at the temperature we deem to be the most representative one. The normalization factor will need to be constant over the full range of temperatures, to allow the HS to follow the behavior of $\beta^3$. We choose the following temperature to be the optimal temperature: $T_{opt} \approx 35°C$.

For this purpose, we impose:

$$HS(h = H) = 1 - K \cdot \widetilde{W}(h = H) = 0$$

and, valid at constant temperature and constant rated speed, we obtain:

$$1 = K \cdot \widetilde{W}(H) = K \cdot \beta^3(T_{opt}) \cdot H^2(T_{opt})$$

$$K = \frac{1}{\beta^3(T_{opt}) \cdot H^2(T_{opt})}$$

It turns out that the $\beta^3$ factor is the one that prevails when computing K(T). Practically, $K(T)$ shows a maximum where $\beta$ shows a minimum, this in turn meaning that normalizing at $T_{opt} \approx 35°C$ gives us lower-health-scores curves.

This fact must not induce us in error when interpreting the results. Indeed, if we run the machine at constant ambient temperature $T_a = 35°C$, we consistently obtain a lifetime close enough to the manufacturer prediction (with differences explainable by the speed correction factor).

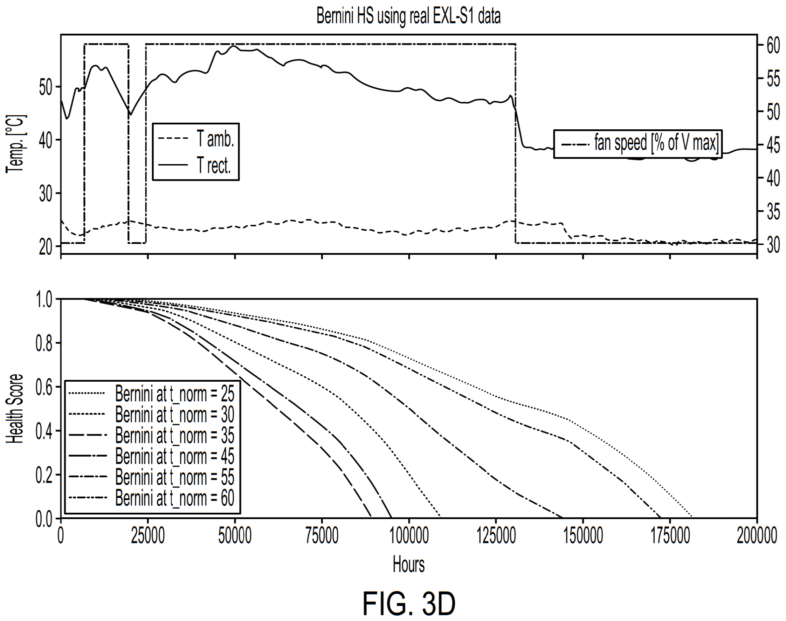

Moreover, we can observe as lower temperatures yield worst results than higher temperatures. Indeed, while the manufacturer curve indicates lower temperatures as better, any temperature departing from the optimal is worse, and lower is even worse than higher (it can be thought that a very dry grease is worse than a very liquid one). As said before, the $\beta$ factor prevails, therefore we see a result moving in the opposite direction than the one from the manufacturer-curve-only approach. Various health scores calculated in accordance with the principles of the present disclosure are shown in FIGS. 3D-3F.

Let "i" identify an interval of hours spanning from a to b (for example: a = 1014 hours and b = 1030 hours), where we know that $T, \omega$ are constant in this interval. Looking for computing $\Delta\widetilde{W}$ over this interval, rather than over a single hour, we obtain:

$$\Delta\widetilde{W}_i = C_i \sum_{h=a(i)}^{b(i)} (2h - 1) = C_i F(i)$$

$$F(i) = (b - a + 1)(b + a - 1)$$

Where $C_i = \beta^3(T_i) \cdot k_\omega(T_i, \omega_i)$, $T_i$, $\omega_i = const.$ over [a, b], and [a, b] depend on each specific interval i.

In terms of this approach, the health score after h hours can be written as:

$$HS(h) = 1 - K \cdot \widetilde{W}(h) = 1 - K \sum_{i=1}^{1(h)} \beta^3(T_i) \cdot k_\omega(T_i, \omega_i) \cdot F(i)$$

where *I(h)* is the last interval, corresponding to the final hour. The summation is carried over a plurality of aggregated intervals, instead of a progressive sequence of single hours, and can be useful depending on how the input data is aggregated.

For example, if the data aggregation is computed on a daily level, we will have:

$$\{(a, b)\} = \{(0, 23), (24, 47), (48, 71), (72, 95), (96, 119), \ldots\}$$

and for the nth day:

$$F(n) = 24^2(2n + 1)$$

While the above formulas are expressed in general terms, these formulas can also be used for intervals of variable duration.

According, a health score is defined herein as a non-increasing quantity that depends on the irreversible consumption of some key element in a piece of equipment we are interested in. In our case, this element is the ball bearing grease:

$$HS(h) = 1 - W(h)$$

As described herein, we have extracted factors to account for time and temperature dependency for the health score, except for a proportionality factor:

$$kT \triangleq \beta^3(T), k_h \triangleq h^2$$

Using the Oh-Azarian approach, we have extracted a factor to account for velocity dependency for the Health Score. This factor further depends on temperature:

$$k_\omega(\omega, T) \triangleq 10^{+(2.81 + 0.012\,T)\frac{(\omega - \omega_n)}{\omega_{lim}}}$$

Combining these 3 factors to a single formula, changing from an integral to a differential form, and imposing the manufacturer lifetime estimation as a constraint, we arrived at the following expression:

$$HS(h) = 1 - K(T) \sum_{j=1}^{h} k_\omega(T, \omega) \cdot \beta^3(T) \cdot (2j - 1)$$

Where:

$$K(T) = \frac{1}{\beta^3(T_{opt}) \cdot H^2(T_{opt})}$$

And *H(T)* represent the expected lifetime from the manufacturer as a function of *T.*

In case of multi-hour aggregation, HS(h) can be calculated according to:

$$HS(h) = 1 - K \cdot \widetilde{W}(h) = 1 - K \sum_{i=1}^{1(h)} \beta^3(T_i) \cdot k_\omega(T_i, \omega_i) \cdot F(i)$$

Finally, as described above, we can apply a correction factor *kL* ($\omega$) into the summation whenever the bearing load exceeds the bearing dynamic capacity one third of its speed.

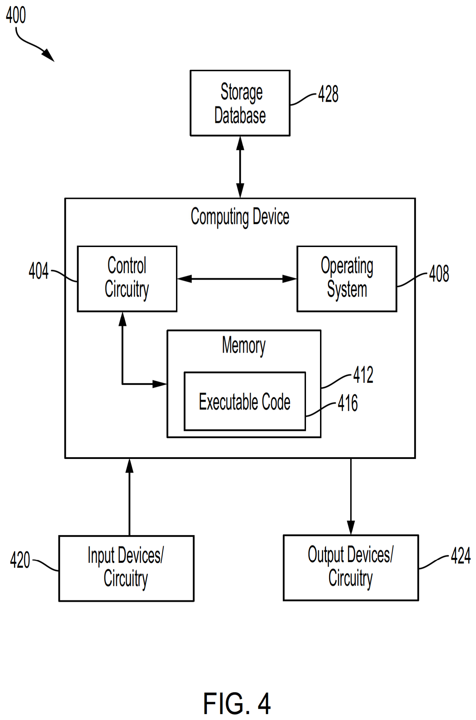

FIG. 4 shows a block diagram of an example computing device 400 configured to implement functions of the systems and methods described herein according to the present disclosure. For example, one or more of the computing devices 400 may implement or be implemented by the one or more components of the system 100, such as the controller 104. Systems described herein may implement a single computing device, a plurality of computing devices, etc., configured to individually and/or collectively perform functions related to the systems and methods of the present disclosure.

The computing device 400 may include control circuitry 404 that may be, for example, one or more processors or processing devices, a central processing unit processor, an integrated circuit or any suitable computing or computational device, an operating system 408, memory 412, executable code 416, input devices or circuitry 420, and output devices or circuitry 424. The control circuitry 404 (or one or more controllers or processors, possibly across multiple units or devices) may be configured to implement functions of the systems and methods described herein. More than one of the computing devices 400 may be included in, and one or more of the computing devices 400 may act as the components of, a system according to examples of the disclosure. Various components of the computing device 400 may be implemented with same or different circuitry, same or different processors or processing devices, etc.

The operating system 408 may be or may include any code segment (e.g., one similar to the executable code 416 described herein) configured and/or configured to perform tasks involving coordination, scheduling, arbitration, supervising, controlling or otherwise managing operation of the control circuitry 404 (e.g., scheduling execution of software programs or tasks or enabling software programs or other hardware modules or units to communicate). The operating system 408 may be a commercial operating system. The operating system 408 may be an optional component (e.g., in some examples, a system may include a computing device that does not require or include the operating system 408). For example, a computer system may be, or may include, a microcontroller, an application specific circuit (ASIC), a field programmable array (FPGA), network controller (e.g., CAN bus controller), associated transceiver, system on a chip (SOC), and/or any combination thereof that may be used without an operating system.

The memory 412 may be or may include, for example, Random Access Memory (RAM), read only memory (ROM), Dynamic RAM (DRAM), Synchronous DRAM (SD-RAM), a double data rate (DDR) memory chip, Flash memory, volatile memory, non-volatile memory, cache memory, a buffer, a short-term memory unit, a long-term memory unit, or other suitable memory units or storage units. The memory 412 may be or may include a plurality of memory units, which may correspond to same or different types of memory or memory circuitry. The memory 412 may be a computer or processor non-transitory readable medium, or a computer non-transitory storage medium, e.g., RAM.

The executable code 416 may be any executable code, e.g., an application, a program, a process, task, or script. The executable code 416 may be executed by the control circuitry 404, possibly under control of the operating system 408. Although, for the sake of clarity, a single item of the executable code 416 is shown, a system according to some examples of the disclosure may include a plurality of executable code segments similar to the executable code 416 that may be loaded into the memory 412 and cause the control circuitry 404 to carry out methods described herein. Where applicable, the terms "process" and "executable code" may be used interchangeably herein. For example, verification, validation and/or authentication of a process may mean verification, validation and/or authentication of executable code.

In some examples, the memory 412 may include non-volatile memory having the storage capacity of a storage system. In other examples, the computing device 400 may include or communicate with a storage system and/or database. Such a storage system may include, for example, flash memory, memory that is internal to, or embedded in, a micro controller or chip, a hard disk drive, a solid-state drive, a CD-Recordable (CD-R) drive, a Blu-ray disk (BD), a universal serial bus (USB) device or other suitable removable and/or fixed storage unit. Content may be stored in the storage system and loaded from the storage system into the memory 412 where it may be processed by the control circuitry 404.

The input circuitry 420 may be or may include any suitable input devices, components, or systems, e.g., physical sensors such as accelerometers, thermometers, microphones, analog to digital converters, etc., a detachable keyboard or keypad, a mouse, etc. The output circuitry 424 may include one or more (possibly detachable) displays or monitors, motors, servo motors, speakers and/or any other suitable output devices. Any applicable input/output (I/O) devices may be connected to the control circuitry 404. For example, a wired or wireless network interface card (NIC), a universal serial bus (USB) device, or external storage device may be included in the input circuitry 420 and/or the output circuitry 424. It will be recognized that any suitable number of input devices and output devices may be operatively connected to the control circuitry 404. For example, the input circuitry 420 and the output circuitry 424 may be used by a technician or engineer in order to connect to the control circuitry 404, update software, and the like.

Examples may include an article such as a computer or processor non-transitory readable medium, or a computer or processor non-transitory storage medium, such as for example memory, a disk drive, or USB flash memory, encoding, including or storing instructions (e.g., computer-executable instructions, which, when executed by a processor or controller, carry out methods disclosed herein), a storage medium such as the memory 412, computer-executable instructions such as the executable code 416, and a controller such as the control circuitry 404.

The storage medium may include, but is not limited to, any type of disk including magneto-optical disks, semiconductor devices such as read-only memories (ROMs), random access memories (RAMs), such as a dynamic RAM (DRAM), erasable programmable read-only memories (EPROMs), flash memories, electrically erasable programmable read-only memories (EEPROMs), magnetic or optical cards, or any type of media suitable for storing electronic instructions, including programmable storage devices.

Examples of the disclosure may include components such as, but not limited to, a plurality of central processing units (CPU) or any other suitable multi-purpose or specific processors or controllers (e.g., controllers similar to the control circuitry 404), a plurality of input units, a plurality of output units, a plurality of memory units, and a plurality of storage units, etc. A system may additionally include other suitable hardware components and/or software components. In some examples, a system may include or may be, for example, a personal computer, a desktop computer, a mobile computer, a laptop computer, a notebook computer, a terminal, a workstation, a server computer, a Personal Digital Assistant (PDA) device, a tablet computer, a network device, or any other suitable computing device.

In some examples, a system may include or may be, for example, a plurality of components that include a respective plurality of central processing units, e.g., a plurality of CPUs as described, a plurality of CPUs embedded in an on-board system or network, a plurality of chips, FPGAs or SOCs, microprocessors, transceivers, microcontrollers, a plurality of computer or network devices, any other suitable computing device, and/or any combination thereof. For example, a system as described herein may include one or more devices such as the control circuitry 404.

The computing device 400 may include and/or communicate with one or more storage devices or databases 428. For example, the storage database 428 may correspond to a storage device (e.g., a semiconductor storage device, such as a solid-state drive (SSD)) of the computing device 400, a remote storage device or database, a cloud computing system, etc. The storage database 428 may store data accessible by one or more components of the systems described herein.

In some examples, the computing device 400 may implement an artificial intelligence (AI) engine configured to execute one or more AI or machine learning (ML) models, etc. trained using data ("training data") obtained during operation. Various components of the training data, an AI engine, ML models, etc. may be stored within the computing device 400 or external to the computing device 400 (e.g., in a remote server, a cloud computing system, etc.).

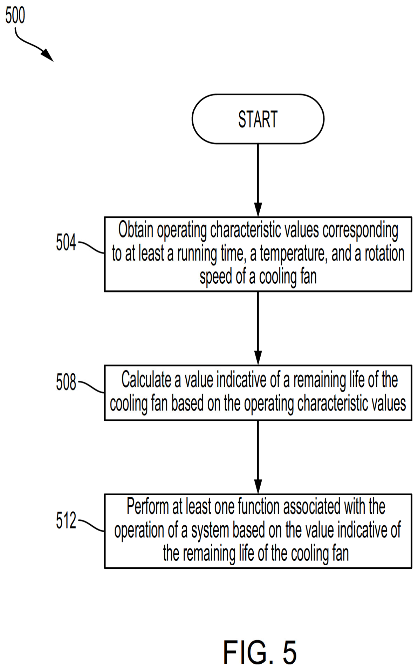

FIG. 5 shows an example method 500 for calculating a remaining life of a cooling fan in accordance with the principles of the present disclosure. A system, one or more controllers, processors, or processing devices, circuitry, etc. as described herein may be configured to execute the steps or functions of the method. For example, the computing device 400 may be configured to executed the method 500.

At 504, the method 500 includes obtaining operating characteristic values corresponding to at least a running time of a cooling fan, a temperature associated with the cooling fan, and a rotation speed of the cooling fan. At 508, the method 500 includes calculating a value indicative of a remaining life of the cooling fan based on the operating characteristic values.

At 512, the method 500 includes performing at least one function associated with the operation of a system associated with the one cooling fan based on the value indicative of the remaining life of the cooling fan. As one example, performing the at least one function includes controlling an operating parameter of the cooling fan (e.g., controlling or limiting a rotation speed of the cooling fan). As another example, performing the at least one function includes controlling an operating parameter of the component of the system (e.g., disabling, pausing, limiting, or reducing an operating or processing speed, temperature, etc. of the component), and generating a notification indicative of the value indicative of the remaining life of the cooling fan (e.g., providing a warning or other notification to a user, generating an indication that the cooling fan needs to be serviced or replaced, etc.).

The foregoing description is merely illustrative in nature and is in no way intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. It should be understood that one or more steps within a method may be executed in different order (or concurrently) without altering the principles of the present disclosure. Further, although each of the examples is described above as having certain features, any one or more of those features described with respect to any example of the disclosure can be implemented in and/or combined with features of any of the other examples, even if that combination is not explicitly described. In other words, the described examples are not mutually exclusive, and permutations of one or more examples with one another remain within the scope of this disclosure.

Spatial and functional relationships between elements (for example, between modules, circuit elements, semiconductor layers, etc.) are described using various terms, including "connected," "engaged," "coupled," "adjacent," "next to," "on top of," "above," "below," and "disposed." Unless explicitly described as being "direct," when a relationship between first and second elements is described in the above disclosure, that relationship can be a direct relationship where no other intervening elements are present between the first and second elements, but can also be an indirect relationship where one or more intervening elements are present (either spatially or functionally) between the first and second elements. As used herein, the phrase at least one of A, B, and C should be construed to mean a logical (A OR B OR C), using a non-exclusive logical OR, and should not be construed to mean "at least one of A, at least one of B, and at least one of C."

In some implementations, a controller is part of a system, which may be part of the above-described examples. Broadly speaking, the controller may be defined as electronics having various integrated circuits, logic, memory, and/or software that receive instructions, issue instructions, control operation, enable cleaning operations, enable endpoint measurements, and the like. The integrated circuits may include chips in the form of firmware that store program instructions, digital signal processors (DSPs), chips defined as application specific integrated circuits (ASICs), and/or one or more microprocessors, or microcontrollers that execute program instructions (e.g., software). Program instructions may be instructions communicated to the controller in the form of various individual settings (or program files), defining operational parameters for carrying out a particular process. The controller, in some implementations, may be a part of or coupled to a computer that is integrated with the system, coupled to the system, otherwise networked to the system, or a combination thereof. For example, the controller may be in the "cloud" or all or a part of a host computer system.

Further examples are set out in the clauses below:

1. A controller for controlling at least one cooling fan associated with a component of a system, the controller comprising:

memory storing instructions; and

one or more processors configured to execute the instructions, wherein executing the instructions causes controller to

obtain operating characteristic values corresponding to at least a running time of the at least one cooling fan, a temperature associated with the at least one cooling fan, and a rotation speed of the at least one cooling fan;

calculate a value indicative of a remaining life of the at least one cooling fan based on the operating characteristic values; and

perform at least one function associated with the operation of the system based on the value indicative of the remaining life.

2. The controller of clause 1, wherein the remaining life corresponds to a remaining operational period prior to at least one of (i) failure of the at least one cooling fan and (ii) effectiveness of the at least one cooling fan being reduced below a threshold.

3. The controller of any one of the preceding clauses, wherein the temperature corresponds to a temperature that the at least one cooling fan is exposed to within the system.

4. The controller of any one of the preceding clauses, wherein calculating the value indicative of the remaining life includes calculating the value based on an expected lifetime of the at least one cooling fan for at least one of a rated speed and a temperature range associated with the at least one cooling fan.

5. The controller of any one of the preceding clauses, wherein calculating the value indicative of the remaining life includes calculating the value based on a predicted condition of lubricant associated with the at least one cooling fan.

6. The controller of any one of the preceding clauses, wherein calculating the value indicative of the remaining life includes calculating a rate of wear of the at least one cooling fan, and wherein the rate of wear increases as at least one of the running time, the temperature, and the rotation speed increases.

7. The controller of any one of the preceding clauses, wherein calculating the value indicative of the remaining life includes calculating the value based on a correction factor, wherein the correction factor corresponds to fan-specific operating parameters associated with the at least one cooling fan, and wherein the fan-specific operating parameters indicate an expected lifetime of the at least one cooling fan within a rated speed range or within a rated temperature range.

8. The controller of any one of the preceding clauses, wherein calculating the value indicative of the remaining life includes calculating the value based on an average temperature that the at least one cooling fan is exposed to during a lifetime of the at least one cooling fan.

9. The controller of any one of the preceding clauses, wherein calculating the value indicative of the remaining life includes calculating the value based on a determination of whether the temperature exceeds a rated temperature range of the at least one cooling fan.

10. The controller of any one of the preceding clauses, wherein performing the at least one function includes at least one of controlling an operating parameter of the at least one cooling fan, controlling an operating parameter of the component of the system, and generating a notification indicative of the value indicative of the remaining life of the at least one cooling fan.

11. A method for controlling at least one cooling fan associated with a component of a system, the controller comprising:

obtaining operating characteristic values corresponding to at least a running time of the at least one cooling fan, a temperature associated with the at least one cooling fan, and a rotation speed of the at least one cooling fan;

calculating a value indicative of a remaining life of the at least one cooling fan based on the operating characteristic values; and

performing at least one function associated with the operation of the system based on the value indicative of the remaining life.

12. The method of clause 11, wherein the remaining life corresponds to a remaining operational period prior to at least one of (i) failure of the at least one cooling fan and (ii) effectiveness of the at least one cooling fan being reduced below a threshold.

13. The method of any one of any one of clauses 11-12, wherein the temperature corresponds to a temperature that the at least one cooling fan is exposed to within the system.

14. The method of any one of any one of clauses 11-13, wherein calculating the value indicative of the remaining life includes calculating the value based on an expected lifetime of the at least one cooling fan for at least one of a rated speed and a temperature range associated with the at least one cooling fan.

15. The method of any one of any one of clauses 11-14, wherein calculating the value indicative of the remaining life includes calculating the value based on a predicted condition of lubricant associated with the at least one cooling fan.

16. The method of any one of any one of clauses 11-15, wherein calculating the value indicative of the remaining life includes calculating a rate of wear of the at least one cooling fan, and wherein the rate of wear increases as at least one of the running time, the temperature, and the rotation speed increases.

17. The method of any one of any one of clauses 11-16, wherein calculating the value indicative of the remaining life includes calculating the value based on a correction factor, wherein the correction factor corresponds to fan-specific operating parameters associated with the at least one cooling fan, and wherein the fan-specific operating parameters indicate an expected lifetime of the at least one cooling fan within a rated speed range or within a rated temperature range.

18. The method of any one of any one of clauses 11-17, wherein calculating the value indicative of the remaining life includes calculating the value based on an average temperature that the at least one cooling fan is exposed to during a lifetime of the at least one cooling fan.

19. The method of any one of any one of clauses 11-18, wherein calculating the value indicative of the remaining life includes calculating the value based on a determination of whether the temperature exceeds a rated temperature range of the at least one cooling fan.

20. The method of any one of any one of clauses 11-19, wherein performing the at least one function includes at least one of controlling an operating parameter of the at least one cooling fan, controlling an operating parameter of the component of the system, and generating a notification indicative of the value indicative of the remaining life of the at least one cooling fan.

Broadly speaking, the controller may be defined as electronics having various integrated circuits, logic, memory, and/or software that receive instructions, issue instructions, control operation, enable cleaning operations, enable endpoint measurements, and the like. The integrated circuits may include chips in the form of firmware that store program instructions, digital signal processors (DSPs), chips defined as application specific integrated circuits (ASICs), and/or one or more microprocessors, or microcontrollers that execute program instructions (e.g., software). Program instructions may be instructions communicated to the controller in the form of various individual settings (or program files), defining operational parameters for carrying out a particular process or method.

## Claims

1. A controller for controlling at least one cooling fan associated with a component of a system, the controller comprising:

   memory storing instructions; and
   one or more processors configured to execute the instructions, wherein executing the instructions causes controller to

   obtain operating characteristic values corresponding to at least a running time of the at least one cooling fan, a temperature associated with the at least one cooling fan, and a rotation speed of the at least one cooling fan;
   calculate a value indicative of a remaining life of the at least one cooling fan based on the operating characteristic values; and
   perform at least one function associated with the operation of the system based on the value indicative of the remaining life.

2. The controller of claim 1, wherein the remaining life corresponds to a remaining operational period prior to at least one of (i) failure of the at least one cooling fan and (ii) effectiveness of the at least one cooling fan being reduced below a threshold.

3. The controller of any one of the preceding claims, wherein the temperature corresponds to a temperature that the at least one cooling fan is exposed to within the system.

4. The controller of any one of the preceding claims, wherein calculating the value indicative of the remaining life includes calculating the value based on an expected lifetime of the at least one cooling fan for at least one of a rated speed and a temperature range associated with the at least one cooling fan.

5. The controller of any one of the preceding claims, wherein calculating the value indicative of the remaining life includes calculating the value based on a predicted condition of lubricant associated with the at least one cooling fan.

6. The controller of any one of the preceding claims, wherein calculating the value indicative of the remaining life includes calculating a rate of wear of the at least one cooling fan, and wherein the rate of wear increases as at least one of the running time, the temperature, and the rotation speed increases.

7. The controller of any one of the preceding claims, wherein calculating the value indicative of the remaining life includes calculating the value based on a correction factor, wherein the correction factor corresponds to fan-specific operating parameters associated with the at least one cooling fan, and wherein the fan-specific operating parameters indicate an expected lifetime of the at least one cooling fan within a rated speed range or within a rated temperature range.

8. The controller of any one of the preceding claims, wherein calculating the value indicative of the remaining life includes calculating the value based on an average temperature that the at least one cooling fan is exposed to during a lifetime of the at least one cooling fan.

9. The controller of any one of the preceding claims, wherein calculating the value indicative of the remaining life includes calculating the value based on a determination of whether the temperature exceeds a rated temperature range of the at least one cooling fan.

10. The controller of any one of the preceding claims, wherein performing the at least one function includes at least one of controlling an operating parameter of the at least one cooling fan, controlling an operating parameter of the component of the system, and generating a notification indicative of the value indicative of the remaining life of the at least one cooling fan.

11. A method for controlling at least one cooling fan associated with a component of a system, the controller comprising:

obtaining operating characteristic values corresponding to at least a running time of the at least one cooling fan, a temperature associated with the at least one cooling fan, and a rotation speed of the at least one cooling fan; calculating a value indicative of a remaining life of the at least one cooling fan based on the operating characteristic values; and performing at least one function associated with the operation of the system based on the value indicative of the remaining life.

12. The method of claim 11, wherein the remaining life corresponds to a remaining operational period prior to at least one of (i) failure of the at least one cooling fan and (ii) effectiveness of the at least one cooling fan being reduced below a threshold.

13. The method of claim 11 or 12, wherein the temperature corresponds to a temperature that the at least one cooling fan is exposed to within the system.

14. The method of any one of claims 11-13, wherein calculating the value indicative of the remaining life includes calculating the value based on an expected lifetime of the at least one cooling fan for at least one of a rated speed and a temperature range associated with the at least one cooling fan.

15. The method of any one of claims 11-14, wherein calculating the value indicative of the remaining life includes calculating the value based on a predicted condition of lubricant associated with the at least one cooling fan; or optionally

wherein calculating the value indicative of the remaining life includes calculating a rate of wear of the at least one cooling fan, and wherein the rate of wear increases as at least one of the running time, the temperature, and the rotation speed increases; or optionally wherein calculating the value indicative of the remaining life includes calculating the value based on a correction factor, wherein the correction factor corresponds to fan-specific operating parameters associated with the at least one cooling fan, and wherein the fan-specific operating parameters indicate an expected lifetime of the at least one cooling fan within a rated speed range or within a rated temperature range; or optionally wherein calculating the value indicative of the remaining life includes calculating the value based on an average temperature that the at least one cooling fan is exposed to during a lifetime of the at least one cooling fan; or optionally wherein calculating the value indicative of the remaining life includes calculating the value based on a determination of whether the temperature exceeds a rated temperature range of the at least one cooling fan; or optionally wherein performing the at least one function includes at least one of controlling an operating parameter of the at least one cooling fan, controlling an operating parameter of the component of the system, and generating a notification indicative of the value indicative of the remaining life of the at least one cooling fan.

FIG. 1

EP 4 786 792 A1

**FIG. 2**

FIG. 3A

EP 4 786 792 A1

FIG. 3B

Ratio beta_T / beta_W vs. hours elapsed

FIG. 3C

EP 4 786 792 A1

EP 4 786 792 A1

Bernini HS using real EXL-S1 data

FIG. 3D

FIG. 3E

FIG. 3F

FIG. 4

500

START

504 — Obtain operating characteristic values corresponding to at least a running time, a temperature, and a rotation speed of a cooling fan

508 — Calculate a value indicative of a remaining life of the cooling fan based on the operating characteristic values

512 — Perform at least one function associated with the operation of a system based on the value indicative of the remaining life of the cooling fan

FIG. 5

Europäisches
Patentamt

European
Patent Office

Office européen
des brevets

# EUROPEAN SEARCH REPORT

**Application Number**

EP 26 15 4320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/213562 A1 (FANG MIN [CN] ET AL) 11 July 2019 (2019-07-11) | 1-4,6,7, 9-15 | INV. F04D17/16 |
| A | * figure 4 * <br> * paragraphs [0006], [0007] * | 5,8 | F04D19/00 F04D27/00 G05B23/02 |
| X | US 2016/132050 A1 (HELLER FRANK [DE] ET AL) 12 May 2016 (2016-05-12) | 1-7,9-15 | H05K7/20 |
| A | * claim 1 * <br> * paragraph [0002] * <br> * paragraph [0010] * <br> * paragraph [0008] * | 8 | |
| X | CN 111 678 681 A (CHINA GREATWALL TECH GROUP CO LTD) 18 September 2020 (2020-09-18) * claim 1 * | 1-4, 10-15 | |
| X | CN 105 868 530 A (LENOVO BEIJING LTD) 17 August 2016 (2016-08-17) * claims 1,2,8,9 * | 1-4, 10-15 | |
| X | CN 114 562 474 A (SUZHOU INSPUR INTELLIGENT TECHNOLOGY CO LTD) 31 May 2022 (2022-05-31) * claim 1 * | 1-4, 10-15 | **TECHNICAL FIELDS SEARCHED (IPC)** <br> F04D <br> H05K <br> G05B |

The present search report has been drawn up for all claims

| Place of search | Date of completion of the search | Examiner |
|---|---|---|
| The Hague | 16 June 2026 | Ingelbrecht, Peter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 786 792 A1**

## ANNEX TO THE EUROPEAN SEARCH REPORT
## ON EUROPEAN PATENT APPLICATION NO.

EP 26 15 4320

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-2026

| Patent document cited in search report | | Publication date | Patent family member(s) | | Publication date |
|---|---|---|---|---|---|
| US 2019213562 | A1 | 11-07-2019 | CA | 3028067 A1 | 05-07-2019 |
| | | | CN | 110006014 A | 12-07-2019 |
| | | | CN | 119042590 A | 29-11-2024 |
| | | | US | 2019213562 A1 | 11-07-2019 |
| | | | US | 2023316236 A1 | 05-10-2023 |
| US 2016132050 | A1 | 12-05-2016 | CN | 105359045 A | 24-02-2016 |
| | | | DE | 102013106838 A1 | 31-12-2014 |
| | | | EP | 3014373 A1 | 04-05-2016 |
| | | | US | 2016132050 A1 | 12-05-2016 |
| | | | WO | 2014207242 A1 | 31-12-2014 |
| CN 111678681 | A | 18-09-2020 | NONE | | |
| CN 105868530 | A | 17-08-2016 | NONE | | |
| CN 114562474 | A | 31-05-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63751040

- US 45304426